# FASCICULE DE BREVET EUROPEEN

(11) **EP 1 292 974 B1**
(45) Date de publication et mention de la délivrance du brevet: **09.08.2006**
(21) Numéro de dépôt: 01945378.6
(22) Date de dépôt: 08.06.2001
(51) Int. Cl.: H01L 21/336, H01L 21/8239, H01L 21/28

(54) **PROCEDE DE REALISATION D'UN COMPOSANT ELECTRONIQUE A SOURCE, DRAIN ET GRILLE AUTO-ALIGNES, EN ARCHITECTURE DAMASCENE.**
VERFAHREN ZUR HERSTELLUNG EINER ELEKTRONISCHEN KOMPONENTE MIT SELBSTJUSTIERTEN SOURCE, DRAIN UND GATE IN DAMASZEN-TECHNOLOGIE
METHOD FOR MAKING AN ELECTRONIC COMPONENT WITH SELF-ALIGNED DRAIN AND GATE, IN DAMASCENE ARCHITECTURE

(30) Priorité: 09.06.2000 FR 0007419
(43) Date de publication de la demande: 19.03.2003
(73) Titulaire: COMMISSARIAT A L'ENERGIE ATOMIQUE, 75752 Paris Cédex 15 (FR)
(72) Inventeur: DELEONIBUS, Simon, F-38640 Claix (FR)
(74) Mandataire: Weber, Etienne Nicolas
(86) Numéro de dépôt international: PCT/FR2001/001776
(87) Numéro de publication internationale: WO 2001/095383

(56) Documents cités:
- FR-A- 2 750 534
- FR-A- 2 757 312
- US-A- 5 391 510
- US-A- 6 033 963

## Description

### Domaine technique

La présente invention concerne un procédé de réalisation de composants électroniques à source, drain et grille auto-alignés. Les composants visés par l'invention peuvent être des transistors à grille isolée tels que les transistors MOS (Métal Oxyde Semiconducteur), par exemple, ou encore des mémoires électroniques à grille double, c'est-à-dire à grille de commande et à grille flottante.

Le procédé de l'invention concerne en particulier la fabrication de ces composants sur un substrat de silicium massif ou sur un substrat à couche mince tel qu'un substrat de type SOI (Silicium sur Isolant).

L'invention trouve des applications dans de nombreux domaines de la microélectronique qui vont de la commutation de puissance aux circuits hyperfréquence, sans oublier les circuits de mémoire.

### Etat de la technique antérieure

Des procédés de fabrication de transistors mettant en oeuvre des techniques d'auto-alignement sont connus, par exemple, dans les documents (1) et (2) dont les références sont précisées à la fin de la présente description.

En particulier le document (1) concerne la fabrication d'un transistor MIS (Métal Isolant Semiconducteur). Il décrit un procédé selon lequel une grille factice est utilisée pour fixer l'emplacement et les dimensions d'une grille définitive formée ultérieurement. La grille définitive est de préférence en un matériau de faible résistivité, tel que du métal par exemple, de façon à réduire la résistance de grille et augmenter la fréquence de coupure du transistor.

Le document (2) indique un procédé qui suggère une siliciuration des régions de source et de drain, de façon à réduire aussi les résistances d'accès de source et de drain. Le procédé du document (2) reste cependant relativement complexe.

### Exposé de l'invention

L'invention a pour but de proposer un procédé de fabrication de composants qui soit différent de ceux des documents indiqués ci-dessus, et qui permette de réduire encore davantage les résistances de grille, de source et de drain.

Un autre but est de proposer un tel procédé dont la mise en oeuvre soit simplifiée.

Un autre but encore est de proposer un tel procédé qui permette une plus grande miniaturisation des composants et donc une plus forte intégration des circuits.

Un but est enfin, en lien avec les aspects ci-dessus, de proposer un procédé permettant d'obtenir des transistors avec une fréquence de coupure particulièrement élevée.

Pour atteindre ces buts, l'invention a plus précisément pour objet un procédé de fabrication d'un composant électronique à source, drain et grille auto-alignés, comprenant les étapes suivantes :
a) la formation sur un substrat de silicium d'une grille factice, ladite grille factice définissant un emplacement pour un canal du composant,
b) l'implantation d'impuretés dopantes dans le substrat, pour former des source et drain de part et d'autre du canal, en utilisant le grille factice comme masque d'implantation,
c) la siliciuration superficielle auto-alignée des source et drain,
d) le dépôt d'au moins une couche de métal, dit de contact, avec une épaisseur totale supérieure à une hauteur de la grille factice, et le polissage de la couche de métal avec arrêt sur la grille factice,
e) le remplacement de la grille factice par au moins une grille définitive, séparée du substrat par une couche d'isolant de grille, et isolée électriquement des source et drain.

Grâce à la couche de métal de contact, mais aussi grâce à la siliciuration auto-alignée des source et drain, la résistance d'accès des source et drain peut être particulièrement réduite en dépit de très faibles dimensions du composant.

Par ailleurs, le recours à une grille factice permet d'obtenir, en fin de procédé, une grille définitive auto-alignée sur les régions de source et de drain. Une telle structure est particulièrement adaptée à la réduction des dimensions du composant et en particulier à des longueurs de grille inférieures à 0,10 µm.

Selon une mise en oeuvre particulière du procédé, la formation de la grille factice peut avantageusement comporter le dépôt d'une première couche de matériau, dit d'adaptation de contraintes, et d'une deuxième couche de matériau, dit d'arrêt de polissage, et la mise en forme de ces couches par gravure selon un masque définissant les dimensions, la forme et l'emplacement de la grille.

A priori, le rôle essentiel de la grille factice serait simplement de "réserver une place" pour la grille définitive réalisée ultérieurement. Cependant, le choix d'une grille factice bicouche permet de faciliter les étapes de procédé ultérieures. La première couche est de préférence une couche présentant un coefficient de dilatation thermique et un paramètre moyen de maille proche de celui du matériau du substrat. Dans le cas d'un substrat à base de silicium monocristallin, la couche d'adaptation de contraintes peut donc être, par exemple, une couche de silicium amorphe ou polycristallin. De plus, la technique de dépôt de ces matériaux est aisée et bien connue.

Le matériau de la deuxième couche peut, de préférence, être choisi pour avoir une bonne résistance à l'abrasion et au polissage. Il permet ainsi de mieux utiliser le grille factice comme repère d'arrêt pour le polissage du métal de contact.

Selon un autre aspect de l'invention, les flancs de la grille factice peuvent être garnis d'une ou de plusieurs couches d'espaceurs latéraux. On entend par couche d'espaceurs latéraux une couche de matériau diélectrique qui tapisse les flancs latéraux d'une grille, c'est-à-dire les flancs sensiblement perpendiculaires au substrat qui porte la grille. Les couches d'espaceurs latéraux peuvent être mises à profit lors de la formation des sources et drain en tant que masques supplémentaires d'implantation. L'utilisation d'espaceurs latéraux pour l'implantation, connue en soi, permet d'obtenir des régions de source et de drain avec des concentrations d'impuretés graduelles.

Dans le cadre de l'invention, lorsqu'ils sont mis en place avant la siliciuration, les espaceurs permettent aussi de protéger la grille factice de la siliciuration, et autorisent un choix plus libre des matériaux de celle-ci.

Enfin, les espaceurs latéraux peuvent avantageusement être utilisés dans la suite du procédé comme moyen d'isolation électrique de la grille définitive, par rapport à la couche de métal de contact.

Les espaceurs latéraux peuvent être des espaceurs à une seule couche ou, de préférence, des espaceurs à deux couches. Là encore, une première couche d'oxyde de silicium permet de limiter les contraintes de contact avec la grille et le substrat - les espaceurs venant effectivement en contact avec une petite portion de substrat -. Une deuxième couche, de nitrure de silicium, est en revanche bien adaptée à la protection de la grille factice, tant contre les oxydations que contre la siliciuration.

L'étape d) de dépôt de métal de contact, évoquée précédemment, peut comporter, selon un perfectionnement, le dépôt d'une première couche de métal puis, au dessus de la première couche, le dépôt d'une deuxième couche de métal présentant une résistance mécanique au polissage supérieure à celle de la première couche. L'épaisseur de la première couche de métal est alors choisie inférieure à la hauteur de la grille factice. Toutefois, l'épaisseur totale des première et deuxième couches est supérieure à la hauteur de la grille factice.

La deuxième couche de métal a pour but de réduire un phénomène de polissage appelé "dishing". Ce phénomène se traduit par une érosion plus rapide du matériau poli dans les régions hautes des marches que dans les régions basses. En d'autres termes, le dépôt de deux couches de métal de contact dans les conditions indiquées ci-dessus permet d'obtenir, après le polissage, une surface libre avec une excellente planéité.

Le métal de contact, et tout au moins la première couche de ce métal, vient prolonger les source et drain en autorisant une très faible résistance d'accès à ces régions.

Le polissage, lorsqu'il atteint le sommet de la grille factice, ou commence à entamer celle-ci, a pour effet, dans la région de la grille, de séparer le métal en contact avec la source de celui en contact avec le drain. Une autre gravure, (qui ne fait pas directement partie du procédé de l'invention) permet, par ailleurs, de découper le métal de contact en dehors de la région active traversée par la grille et donc d'achever l'isolation électrique entre drain et source.

Les couches de métal de contact sont formées avant le remplacement de la grille factice par la grille définitive. Il convient donc, pour éviter que le matériau de la grille définitive, avec une résistivité de préférence faible, ne vienne court-circuiter la source et le drain, de prévoir une isolation en surface des couches de contact dans les régions de source et de drain. Cette opération pourrait éventuellement avoir lieu en déposant une couche de matériau diélectrique. Selon un aspect particulier de l'invention cependant, le procédé peut comporter une oxydation superficielle des couches de métal. L'oxydation permet ainsi de garantir, de façon simple et sûre, l'isolation électrique entre source, grille et drain. Elle évite de plus toute opération de masquage.

Dans des étapes ultérieures de la fabrication du composant, il est possible de pratiquer des ouvertures dans l'oxyde des couches de métal de contact pour mettre en place des prises de contact pour des lignes d'interconnexion.

L'élimination de la grille factice peut comporter une ou plusieurs gravures sélectives permettant de retirer les couches qui la composent. Elle est suivie par la mise en place d'une couche d'isolant de grille sur le substrat, dans le puits laissé par la grille factice.

Une étape suivante consiste à mettre en place une ou plusieurs couches de matériau conducteur, ou tout au moins de faible résistivité, séparées éventuellement par une couche diélectrique. Ces couches forment une ou plusieurs grilles.

Plus précisément, lorsque le composant que l'on souhaite réaliser est un transistor, une ou plusieurs couches conductrices sont prévues pour former une grille unique.

En revanche, lorsque le composant est une mémoire, il est possible de déposer d'abord une première couche conductrice, puis une deuxième couche conductrice, séparée de la première couche conductrice par une couche de matériau diélectrique. Les première et deuxième couches conductrices constituent alors respectivement les grilles flottante et de commande. La couche diélectrique constitue une couche d'isolation inter-grille.

Il convient de préciser que les couches conductrices et diélectriques mentionnées ci-dessus peuvent être homogènes ou formées d'empilements de plusieurs sous-couches.

La ou les couches qui constituent la structure de grille, sont déposées de préférence avec une épaisseur totale supérieure ou égale à la hauteur de la grille factice éliminée, de façon à pouvoir subir une opération de planage.

D'autres caractéristiques et avantages de l'invention ressortirant de la description qui va suivre, en référence aux figures des dessins annexés. Cette description est donnée à titre purement illustratif et non limitatif.

### Brève description des figures.

- Les figures 1 à 3 sont des illustrations, sous forme de coupes schématiques, d'étapes de fabrication d'un composant avec une grille factice.
- Les figures 4 à 5 sont des coupes schématiques illustrant la formation d'accès de source et de drain pour un composant conforme à la figure 3.
- La figure 6 est une coupe schématique d'un composant conforme à la figure 5 et illustre une étape d'isolation électrique des accès de source et de drain.
- Les figures 7 à 9 sont des coupes schématiques illustrant le remplacement de la grille factice par une grille définitive.
- Les figures 10 et 11 sont des coupes schématiques illustrant une variante des étapes des figures 8 et 9 pour la fabrication d'un autre type de composant.
- La figure 12 montre, en coupe, une portion de circuit intégré avec des composants conformes à l'invention, et illustre la réalisation d'une interconnexion.

### Description détaillée de modes de mise en oeuvre de l'invention.

Des parties identiques, similaires ou équivalentes des figures décrites ci-après portent les mêmes références numériques, de façon à faciliter le report d'une figure à l'autre. Par ailleurs, bien que la description qui suit ne concerne que la fabrication de composants sur un substrat massif, en l'occurrence de silicium, il convient de souligner que les procédés restent identiques pour la formation des composants sur des substrats à couche mince isolée, tels que les substrats de type SOI (silicium sur isolant/silicon on insulator).

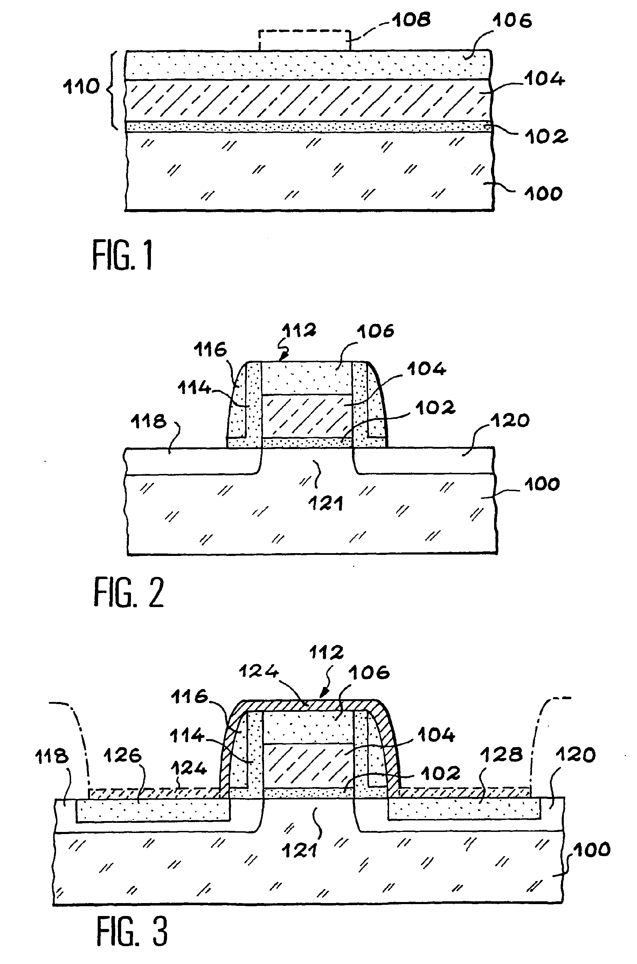

La figure 1 montre un substrat de silicium 100 dont la surface a été oxydée afin de former une couche 102 d'oxyde de silicium, dite couche piédestal.

Sur la couche 102 sont successivement déposées une couche de silicium polycristallin ou amorphe 104, puis une couche de nitrure de silicium 106. L'ensemble de ces couches forme un empilement 110. L'épaisseur totale des couches 104 et 106 est, par exemple, de l'ordre de 100 à 300 nm et correspond sensiblement à l'épaisseur de la grille du transistor qui sera finalement obtenu au terme du procédé de fabrication.

Un masque de gravure 108, représenté en trait discontinu, tel qu'un masque de résine photosensible, est formé sur la couche 106 de nitrure de silicium. Ce masque définit l'emplacement, la taille et la forme d'une grille factice que l'on souhaite réaliser dans l'empilement 110.

Les couches 102, 104 et 106 de l'empilement 110 sont éliminées par gravure, à l'exception d'une portion protégée par le masque 108.

Cette portion de l'empilement forme le corps de la grille factice, repérée avec la référence 112 sur la figure 2.

La formation de la grille factice est suivie d'une première implantation d'ions à faible dose. Selon que le composant que l'on souhaite réaliser est du type PMOS ou NMOS, les ions sont choisis de façon à réaliser des zones d'un type de conductivité p ou n. Il s'agit par exemple d'ions de bore pour les composants PMOS et des ions de phosphore ou d'arsenic pour les composants NMOS.

La première implantation est suivie par la formation sur le ou les flancs de la grille factice d'espaceurs latéraux 114, 116 visibles à la figure 2.

Les espaceurs latéraux comportent une première couche d'oxyde de silicium 114 en contact avec les couches 104 et 106 de la grille factice et une deuxième couche 116, superficielle, de nitrure de silicium recouvrant la couche d'oxyde. La première couche d'espaceur 114 a essentiellement pour rôle de limiter les contraintes de contact avec les couches de matériau de la grille factice, et notamment avec le silicium poly-cristallin. Elle limite aussi les contraintes de contact avec une petite portion de substrat qu'elle touche à la base de la grille factice.

La deuxième couche d'espaceur a essentiellement pour rôle de protéger la grille factice des traitements ultérieurs du procédé, et en particulier les traitements d'oxydation.

La formation des espaceurs latéraux peut avoir lieu selon des techniques connues en soi qui comprennent pour l'essentiel le dépôt en pleine plaque des matériaux sélectionnés, puis la gravure anisotrope de ces matériaux pour n'en laisser subsister qu'une faible épaisseur sur les flancs de la grille factice.

Eventuellement, après la formation des espaceurs latéraux, une deuxième implantation d'impuretés peut être conduite à plus forte dose. La deuxième implantation utilise alors la grille factice, élargie par les espaceurs latéraux, comme masque d'implantation. Elle permet d'obtenir dans le substrat des régions 118,120 de source et de drain graduelles avec un dopage qui diminue en allant vers le canal 121 situé sous la grille factice 112. Le caractère graduel des régions de source et de drain n'est pas représenté sur les figures pour des raisons de clarté.

La figure 3 montre une étape suivante qui consiste à effectuer une siliciuration sélective du substrat dans les régions de source et de drain. Cette opération comporte le dépôt d'une couche 124 de métal tel que, par exemple, du titane ou du nickel puis un traitement thermique à une température suffisante pour provoquer une réaction de siliciuration entre le métal et le silicium du substrat.

La siliciuration est qualifiée de sélective dans la mesure où elle est limitée aux zones dans lesquelles le métal de la couche 124 est directement en contact avec du silicium. On peut observer sur la figure 3 que la couche de métal 124 a disparu au dessus des régions de source et de drain pour y former des couches superficielles 126,128 de siliciure. En revanche, la couche de métal 124 persiste sur le dessus et sur les flancs de la grille factice 112. En effet, sur ces parties, le nitrure de silicium des couches 106 et 116 de la grille factice et des espaceurs, a empêché la siliciuration.

La figure 3, légèrement élargie par rapport à la figure 2 montre la possibilité de mettre en commun la source et le drain avec d'autres composants. Sur la figure 3, les emplacements des grilles des autres composants ont été esquissés, sous forme d'amorces, en trait mixte.

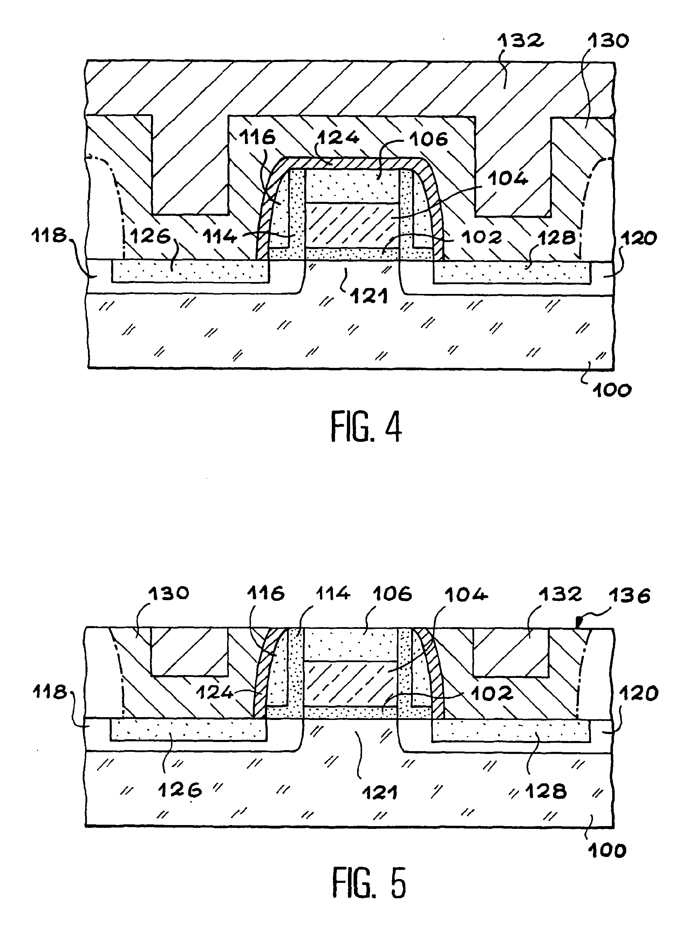

La figure 4 montre la formation des accès de faible résistivité aux régions de source et de drain. Cette opération comporte le dépôt conforme d'une première couche 130 de métal, dit de contact, puis d'une deuxième couche 132 de métal de contact. Le premier métal de contact peut être choisi par exemple parmi le tungstène ou le titane.

Le deuxième métal de contact, choisi de préférence avec une résistance à l'abrasion supérieure à celle du premier métal de contact, peut être sélectionné, par exemple, parmi le tantale, le nitrure de tantale, le nitrure de titane, ....

Dans l'exemple illustré, l'épaisseur totale des deux couches de métal de contact est supérieure ou égale à la hauteur de la grille factice, de façon à pouvoir effectuer, par la suite, un planage avec arrêt sur la grille factice.

Le résultat du planage est montré sur la figure 5. On peut observer que le polissage a lieu plus précisément avec un arrêt sur la deuxième couche 106 de matériau de la grille factice, en l'occurrence la couche de nitrure de silicium.

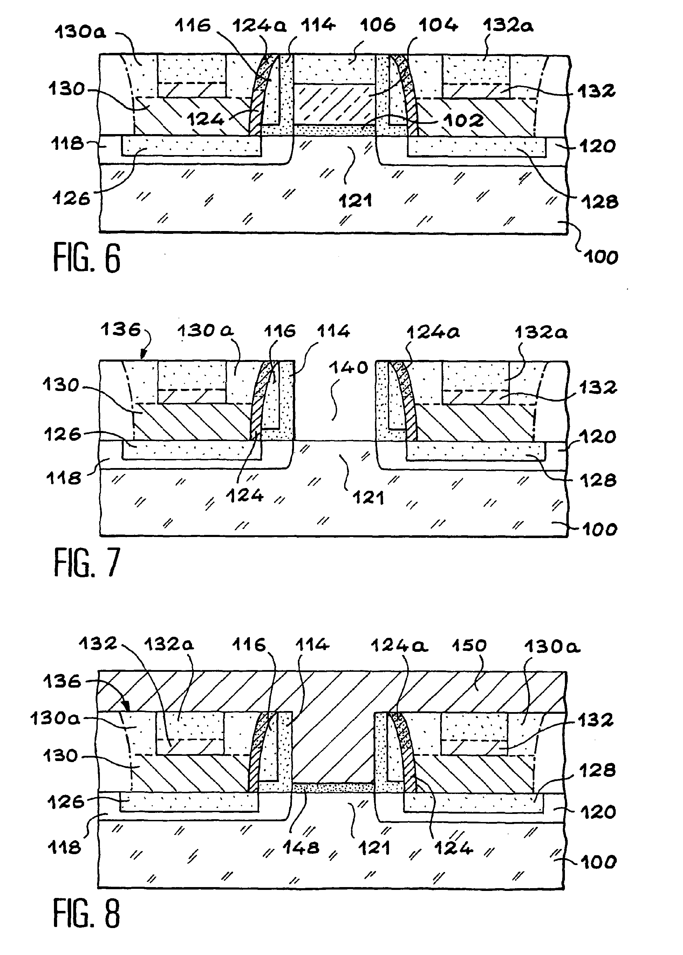

La couche de métal de siliciuration 124 se trouve éliminée sur le dessus de la grille factice et une isolation électrique des régions de source et de drain peut être obtenue. On rappelle qu'en dehors de la région active, dont l'extension est généralement inférieure à la longueur de la grille dans une direction perpendiculaire au plan des figures, une gravure appropriée permet de façon connue de fixer les limites des parties conductrices et d'éviter ainsi tout court-circuit entre ces parties. Par ailleurs l'isolation est aussi obtenue au moyen d'une oxydation décrite ci-après, en référence à la figure 6, et opérée dans une étape de procédé subséquente.

Grâce à l'utilisation de deux matériaux de contact différents, une surface supérieure 136 avec une bonne planéité peut être obtenue.

La figure 6 montre une étape ultérieure qui consiste à conférer aux matériaux affleurant à la surface supérieure 136 un caractère isolant. Lors de cette étape on effectue une oxydation en soumettant la structure à une atmosphère oxydante. L'oxydation concerne en particulier les métaux de contact déjà évoqués dans la description qui précède. Pour faciliter la lecture de la figure 6 les parties oxydées sont repérées avec les mêmes références que les parties correspondantes non oxydées, auxquelles on a toutefois ajouté la lettre a. Les parties oxydées 124a,130a et 132a sont ainsi respectivement les parties superficielles oxydées du métal utilisé initialement pour la siliciuration, et préservé sur les flancs de la grille, du premier métal de contact, et du deuxième métal de contact. Leur oxydation confère aux métaux un caractère isolant électrique.

La figure 7 montre la structure obtenue après le retrait de la grille factice. Le retrait est opéré en attaquant sélectivement le nitrure de silicium de la deuxième couche 106 de la grille factice puis en attaquant le silicium polycristallin de la première couche. Lors de ces gravures la couche d'oxyde de piédestal 102 peut être utilisée comme arrêt de gravure. Cette couche est ensuite également éliminée. Les agents de gravure peuvent être, par exemple, le HBr ou le SF₆ pour la gravure du nitrure de silicium et le HBr+Cl₂ pour la gravure du silicium polycristallin. L'oxyde peut être éliminé avec du HF dilué. Lors de cette étape, une partie des couches 124a, 130a et 132a est également éliminée. Aussi, lors de l'oxydation de la figure 6, on cote l'épaisseur d'oxyde pour tenir compte de cette gravure partielle des couches 124a, 130a et 132a.

Le retrait de la grille factice libère un puits repéré avec la référence 140.

La figure 8 montre la réalisation de la grille définitive. Cette opération comprend la formation d'une couche d'isolant de grille 148, par exemple par oxydation du silicium du substrat sous-jacent, ou par dépôt d'un matériau diélectrique, puis le dépôt d'une couche de matériau de grille 150, de préférence en un métal choisi, par exemple parmi : W, TaN, W/TiN, Ti, TaN, Cu/TaN, W/Pt, N/Pt, W/Nb ou W/RuCa.

La couche 150 peut être une couche massive ou éventuellement composée d'une combinaison de deux ou de plusieurs des matériaux mentionnés. L'épaisseur de la ou des couches de grille 150 est suffisante pour combler le puits laissé par le retrait de la grille factice et pour déborder sur la face supérieure plane 136 définie par le planage.

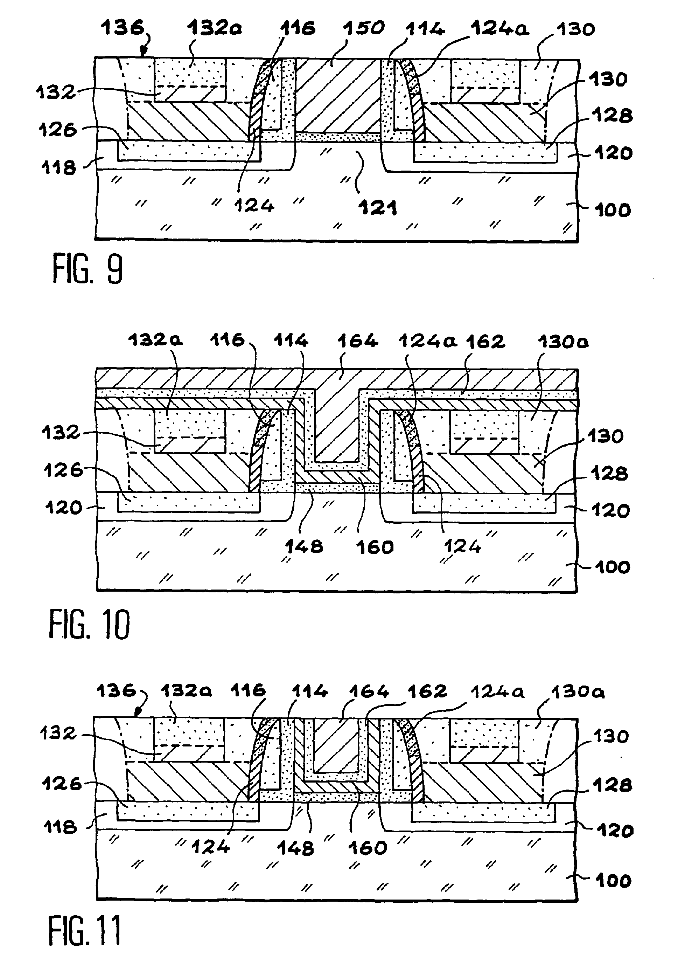

Un second planage permet, comme le montre la figure 9 d'éliminer le matériau de la couche de grille 150 au dessus des source et drain, en ne préservant que du matériau dans le puits. La grille, qui affleure à la surface supérieure 136, est également repérée par la référence 150. Le composant finalement obtenu est un transistor à effet de champ et présente une structure de type damascène.

Les figures ne montrent pas la réalisation de prises de contact sur la grille, la source et le drain. Ces opérations, bien connues en soi dans le domaine de la microélectronique, ne font pas partie au sens stricte du procédé de fabrication du transistor.

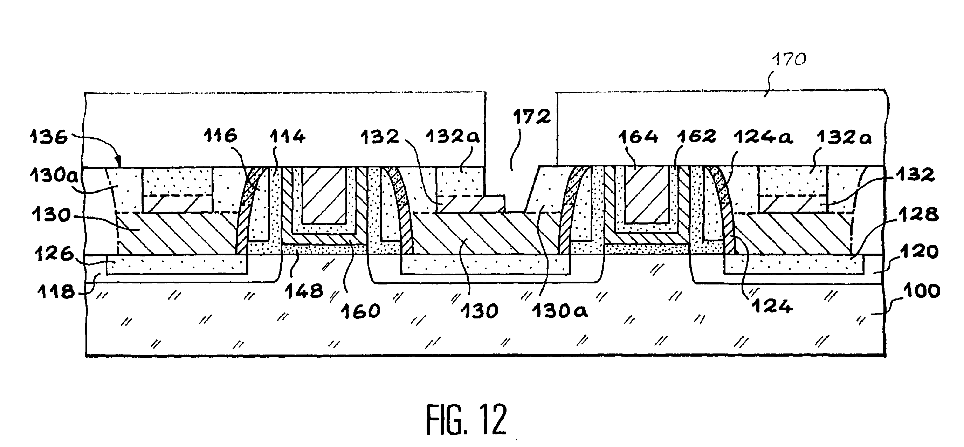

Les figures 10 et 11 montrent la fabrication d'un autre composant, et en particulier d'une mémoire, à partir d'une structure telle que décrite en référence à la figure 7.

Une première couche de grille 160 présentant une épaisseur inférieure à la profondeur du puits 140 laissé par la grille factice, c'est à dire inférieure à la hauteur de la grille factice éliminée, est formée au dessus de la couche 148 d'isolant de grille qui tapisse le fond du puits. La première couche de grille 160 recouvre également la surface supérieure libre 136 de la structure.

Au-dessus de la première couche de grille on dépose une couche diélectrique inter-grille 162, dont l'épaisseur, ajoutée à celle de la première couche de grille, est toujours inférieure à la hauteur de la grille factice (éliminée).

Enfin, une deuxième couche de grille 164 est déposée sur la couche inter-grille 162. L'épaisseur de la deuxième couche de grille est suffisante pour combler, avec les autres couches déposées, le puits laissé par l'élimination de la grille factice.

Il convient de préciser que les couches mentionnées ci-dessus peuvent chacune être formée d'un empilement de plusieurs sous-couches. En particulier, la couche inter-grille 162 peut être formée d'un empilement nitrure/oxyde/nitrure choisi pour sa constante diélectrique particulièrement élevée. Les matériaux sélectionnées pour les première et deuxième couches de grille peuvent être ceux mentionnés précédemment pour la fabrication de la grille du transistor.

Un planage des couches de grille et d'inter-grille, avec arrêt sur les oxydes de métal 124a, 130a, 132a permet d'obtenir une structure telle que représentée à la figure 11. On peut observer que la première couche de grille, de même que la couche inter-grille, présentent une forme en U, en section selon un plan parallèle au plan de la figure s'étendant sensiblement dans une direction source-grille-drain. La deuxième couche de grille 164 comble la forme en U.

Cette forme particulière permet d'augmenter les surfaces en regard entre les première et deuxième couches de grille sans pour autant augmenter les surfaces en regard entre la première couche de grille et le substrat. Comme les première et deuxième couches de grille forment, après le planage, respectivement la grille flottante et la grille de commande d'une mémoire, la structure de la figure 11 permet de disposer d'une capacité élevée entre la grille de commande et la grille flottante et une capacité faible entre la grille flottante et le canal (substrat). Comme par ailleurs les résistances d'accès de source et de drain sont très faibles en raison de l'utilisation du métal de contact, une fréquence de fonctionnement élevée de la mémoire peut être obtenue, tant en lecture qu'en écriture.

Lorsqu'un transistor ou une mémoire tels que décrits ci dessus sont intégrés dans un circuit, des prises de contact sont effectuées sur les région de source, de drain, et de grille. Celles ci comportent, par exemple, la formation d'ouvertures dans les couches d'oxyde qui recouvrent la source et le drain, puis la mise en place d'un métal d'interconnexion dans les ouvertures pour relier le métal de contact non oxydé à des lignes d'interconnexion. Bien que de telles opérations ne fassent plus partie de la fabrication des composants et qu'elles soient bien connues en soi, la figure 12 donne une illustration d'une opération d'interconnexion de drain d'un composant de mémoire, tel que décrit précédemment, avec un composant voisin.

Une couche 170 de matériau isolant tel que SiO₂ est déposée sur la surface libre 136 des composants, d'est à dire la surface obtenue par le dernier planage. Cette couche permet d'éviter un court circuit entre un matériau d'interconnexion (non représenté) et d'autres parties des composants.

Une ouverture 172 pratiquée dans la couche isolante 170 se prolonge à travers les parties oxydées 130a, 132a des première et deuxième couches de métal de contact pour mettre à nu des parties non oxydées 130, 132 de ces couches. La figure 12 permet de constater que les exigences d'alignement de l'ouverture 172 dans la couche d'isolant 170 ne sont pas très élevées. Il suffit qu'elle coïncide avec la région de source ou de drain sélectionnée, sans correspondre nécessairement au milieu de cette région. Le fait que différents matériaux soient rencontrés lors de la réalisation de l'ouverture 172, explique le fond en marche d'escalier de l'ouverture représentée à la figure 12.

### DOCUMENTS CITES

*(1)*
   FR-A-2 757 312
*(2)*
   FR-A-2 750 534

## Revendications

1. Procédé de fabrication d'un composant électronique à source, drain et grille auto-alignés, comprenant les étapes suivantes :
a) la formation sur un substrat (100) de silicium d'une grille factice (112), ladite grille factice définissant un emplacement pour un canal (121) du composant,
b) au moins une implantation d'impuretés dopantes dans le substrat, pour former une source (118) et un drain (120) de part et d'autre du canal, en utilisant la grille factice comme masque d'implantation,
c) la siliciuration superficielle auto-alignée des source et drain,
d) le dépôt d'au moins une couche de métal (130, 132), dit de contact, avec une épaisseur totale supérieure à une hauteur de la grille factice, et polissage de la couche de métal avec arrêt sur la grille factice,
e) le remplacement de la grille factice par au moins une grille définitive (150, 160, 164), séparée du substrat par une couche d'isolant de grille (148), et isolée électriquement de la source et du drain.

2. Procédé selon la revendication 1, dans lequel l'étape d) comporte le dépôt d'une première couche de métal (130) et, au dessus de la première couche, une deuxième couche de métal (132) présentant une résistance mécanique au polissage supérieure à celle de la première couche, l'épaisseur de la première couche de métal étant inférieure à la hauteur de la grille factice, mais l'épaisseur totale des première et deuxième couches étant supérieure à la hauteur de la grille factice.

3. Procédé selon la revendication 1, comprenant en outre, avant la siliciuration, la formation d'espaceurs latéraux (114, 116) sur les flancs de la grille factice.

4. Procédé selon la revendication 3, dans lequel on forme des espaceurs bicouche comprenant une couche d'accrochage (114) en oxyde de silicium, en contact avec la grille factice et une couche superficielle (116) de nitrure de silicium.

5. Procédé selon la revendication 2, dans lequel le premier métal est choisi parmi le tungstène et le titane et dans lequel le deuxième métal est choisi parmi le TaN, Ta et TiN.

6. Procédé selon la revendication 1, comprenant, après le polissage, une oxydation superficielle de la ou des couches de métal.

7. Procédé selon la revendication 1, dans lequel on utilise un substrat massif.

8. Procédé selon la revendication 1, dans lequel on utilise un substrat de type silicium sur isolant.

9. Procédé selon la revendication 1 dans lequel l'étape e), comprend l'élimination de la grille factice, la formation de la couche d'isolant de grille (148), le dépôt d'au moins une couche de métal (150, 160, 164), dit de grille, avec une épaisseur globale supérieure ou égale à la hauteur de la grille factice éliminée, et la mise en forme de ladite couche de métal.

10. Procédé selon la revendication 9, comprenant, après la formation de la couche d'isolant de grille (148), le dépôt d'une première couche de métal de grille (160), le dépôt d'au moins une couche diélectrique inter-grille (162), et le dépôt d'une deuxième couche de métal de grille (164).

## Claims

1. , Method for fabricating an electronic component with self-aligned source, drain and gate, comprising the following steps:
a) the formation of a dummy gate (112) on a silicon substrate (100), said dummy gate defining a position for a channel (121) of the component,
b) at least one implantation of doping impurities in the substrate, to form a source (118) and a drain (120) either side of the channel, using the dummy gate as implanting mask,
c) superficial, self-aligned siliciding of the source and drain,
d) depositing at least one layer of so-called contact metal (130, 132) having a total thickness greater than the height of the dummy gate, and polishing the metal layer stopping at the dummy gate,
e) replacing the dummy gate by at least one final gate (150, 160, 164) separated from the substrate by a gate insulating layer (148), and electrically insulated from the source and drain.

2. Method according to claim 1, in which step d) comprises the depositing of a first metal layer (130) and, above the first layer, a second metal layer (132) having greater mechanical resistance to polishing than the first layer, the thickness of the first metal layer being less than the height of the dummy gate, but the total thickness of the first and second layers being greater than the height of the dummy gate.

3. Method according to claim 1 also comprising, before siliciding, the formation of side spacers (114, 116) on the sides of the dummy gate.

4. Method according to claim 3, in which dual-layer spacers are formed comprising an attachment layer (114) in silicon oxide, in contact with the dummy gate, and a superficial layer (116) in silicon nitride.

5. Method according to claim 2, in which the first metal is chosen from among tungsten and titanium, and in which the second metal is chosen from among TaN, Ta and TiN.

6. Method according to claim 1 comprising, after polishing, superficial oxidation of the metal layer or layers.

7. Method according to claim 1, in which a solid substrate is used.

8. Method according to claim 1, in which a substrate of silicon on insulator type is used.

9. Method according to claim 1, in which step e) comprises the removal of the dummy gate, formation of the gate insulating layer (148), depositing at least one metal layer (150, 160, 164), so-called gate layer, having an overall thickness equal to or greater than the height of the removed dummy gate, and forming said metal layer.

10. Method according to claim 9 comprising, after the formation of the gate insulating layer (148), the depositing of a first gate metal layer (160), the depositing of at least one inter-gate dielectric layer (162), and the depositing of a second gate metal layer (164).

## Patentansprüche

1. Verfahren zur Herstellung einer elektronischen Komponente mit Source, Drain und Gate, die selbstjustiert sind, das die folgenden Stufen umfasst:
a) Bildung eines Schein-Gate (112), das einen Ersatz für einen Kanal (121) der Komponente darstellt, auf einem Silicium-Substrat (100),
b) mindestens eine Implantation von dotierenden Verunreinigungen in das Substrat zur Bildung einer Source (118) und eines Drain (120) beiderseits des Kanals unter Verwendung des Schein-Gates als Implantations-Maske,
c) selbstjustierte Oberflächen-Silicierung der Source und des Drain,
d) Abscheidung mindestens einer Metallschicht (130, 132), der Kontaktschicht, mit einer Gesamtdicke, die größer ist als die Höhe des Schein-Gates, und Polieren der Metallschicht mit einer Unterbrechung auf dem Schein-Gate, und
e) Ersatz des Schein-Gates durch mindestens ein endgültiges Gate (150, 160,164), das durch eine isolierende Gate-Schicht (148) von dem Substrat getrennt ist und das gegenüber der Source und dem Drain elektrisch isoliert ist.

2. Verfahren nach Anspruch 1, worin die Stufe (d) umfasst die Abscheidung einer ersten Metallschicht (130) und, auf der ersten Metallschicht, einer zweiten Metallschicht (132), die dem Polieren einen mechanischen Widerstand entgegensetzt, der höher ist als derjenige der ersten Schicht, wobei die Dicke der ersten Metallschicht geringer ist als die Höhe des Schein-Gates, die Gesamtdicke der ersten und zweiten Metallschichten jedoch größer ist als die Höhe des Schein-Gates.

3. Verfahren nach Anspruch 1, das außerdem vor der Silicierung umfasst die Bildung von seitlichen Abstandhaltern (114, 116) auf den Flanken des Schein-Gates.

4. Verfahren nach Anspruch 3, in dem Zwei-Schichten-Abstandhalter gebildet werden, die umfassen eine Verankerungsschicht (114) aus Siliciumoxid, die in Kontakt steht mit dem Schein-Gate, und eine Oberflächenschicht (116) aus Siliciumnitrid.

5. Verfahren nach Anspruch 2, bei dem das erste Metall ausgewählt wird aus der Gruppe Wolfram und Titan und bei dem das zweite Metall ausgewählt wird aus der Gruppe TaN, Ta und TiN.

6. Verfahren nach Anspruch 1, das nach dem Polieren eine Oberflächenoxidation der Metallschicht(en) umfasst.

7. Verfahren nach Anspruch 1, bei dem man ein massives Substrat verwendet.

8. Verfahren nach Anspruch 1, bei dem man ein Substrat vom Silicium-Typ auf der Isolierschicht (dem Isolator) verwendet.

9. Verfahren nach Anspruch 1, in dem die Stufe (e) umfasst die Eliminierung des Schein-Gates, die Bildung der isolierenden Gate-Schicht (148), die Abscheidung mindestens einer Metallschicht (150, 160, 164), als Gate bezeichnet, mit einer Gesamtdicke, die größer ist als oder gleich ist der Höhe des eliminierten Schein-Gates, und das Formen der genannten Metallschicht.

10. Verfahren nach Anspruch 9, das nach der Bildung der isolierenden Gate-Schicht (148) umfasst die Abscheidung einer ersten Gate-Metallschicht (160), die Abscheidung mindestens einer dielektrischen Gate-Zwischenschicht (162) und die Abscheidung einer zweiten Gate-Metallschicht (164).
